# EUROPEAN PATENT SPECIFICATION

(11) **EP 4 006 959 B1**
(45) Date of publication and mention of the grant of the patent: **01.11.2023**
(21) Application number: 20847093.0
(22) Date of filing: 20.07.2020
(51) Int. Cl.: H01L 21/60, H05K 3/34, B23K 35/38

(54) **SOLDER-ATTACHED PRODUCT MANUFACTURING DEVICE, AND SOLDER-ATTACHED PRODUCT MANUFACTURING METHOD**
VERFAHREN ZUR HERSTELLUNG VON LOTVERBUNDENEM PRODUKT UND VERFAHREN ZUR HERSTELLUNG VON LOTVERBUNDENEM PRODUKT
DISPOSITIF DE FABRICATION D'UN PRODUIT FIXÉ PAR BRASURE ET PROCÉDÉ DE FABRICATION D'UN PRODUIT FIXÉ PAR BRASURE

(30) Priority: 26.07.2019 JP 2019138130; 04.06.2020 JP 2020097848
(43) Date of publication of application: 01.06.2022
(73) Proprietor: Origin Company, Limited, Saitama-shi Saitama 338-0823 (JP)
(72) Inventor: OZAWA, Naoto, Saitama-shi, Saitama 338-0823 (JP); MATSUDA, Jun, Saitama-shi, Saitama 338-0823 (JP); MARUYAMA, Megu, Saitama-shi, Saitama 338-0823 (JP); SUZUKI, Takayuki, Saitama-shi, Saitama 338-0823 (JP); NAGAHAMA, Masanobu, Saitama-shi, Saitama 338-0823 (JP)
(74) Representative: Wallin, Nicholas James
(86) International application number: PCT/JP2020/028113
(87) International publication number: WO 2021/020213

(56) References cited:
- JP-A- H0 685 444
- JP-A- H0 685 444
- JP-A- H06 291 457
- JP-A- H06 291 457
- JP-A- 2003 188 525
- JP-U- H 044 782
- US-A- 2 689 807
- US-A- 2 727 834

## Description

### TECHNICAL FIELD

The present invention relates to a soldered product manufacturing device and a method for manufacturing a soldered product, and particularly relates to a soldered product manufacturing device and a method for manufacturing a soldered product that increase the speed of reducing oxide while suppressing adhesion of unnecessary substances to a substrate.

### BACKGROUND ART

A substrate on which solder bumps are formed, which is used in a reflow solder process for mounting an electronic part on the substrate, is manufactured by arranging a mixture of solder paste and flux on the substrate, heating and melting the mixture to form solder bumps, and finally washing the entire substrate to remove a residue of the flux and the like and thereafter drying the substrate (see Japanese Patent No. 6274341, for example). JPH06291457A discloses a soldering method is composed of a process in which an electronic component is mounted on a board in such a way that the electronic component comes into contact with a soldering part on the board, of a process in which nonflux-type solder is supplied to a part near the soldering part on the board, of a reduction process in which hydrogen gas at the temperature of the melting point or higher of solder is blown to the soldering part for a short time and of a process in which the solder is heated and melted in the atmosphere of hydrogen after the hydrogen gas has been blown. When the hydrogen gas at the melting point or higher of the solder is blown to the soldering part for a short time, an oxide film on the surface of the soldering part is reduced and removed.

### SUMMARY OF THE INVENTION

### PROBLEM TO BE SOLVED BY THE INVENTION

If solder paste containing flux is used when forming solder bumps, trouble must be taken to perform washing in order to remove a residue of the flux. Reducing and removing an oxide film using formic acid, instead of using flux, when forming solder bumps eliminates the need for subsequent washing, which simplifies the process. In forming solder bumps through reflow using formic acid, however, components of the solder and/or the substrate and/or the formic acid are occasionally evaporated when the solder and the substrate are heated, the evaporated components (substances) are diffused and deposited on the inner walls and the like of a chamber, and the deposited substances are occasionally scattered to adhere to the substrate. In the case where an oxide film formed on the solder is reduced and removed using formic acid, a processing time is required before the formic acid reacts with the oxide, and the processing time is preferably as short as possible.

In view of the foregoing issue, the present invention relates to providing a soldered product manufacturing device and a method for manufacturing a soldered product that increase the speed of reducing oxide while suppressing adhesion of unnecessary substances to a substrate.

### MEANS FOR SOLVING THE PROBLEM

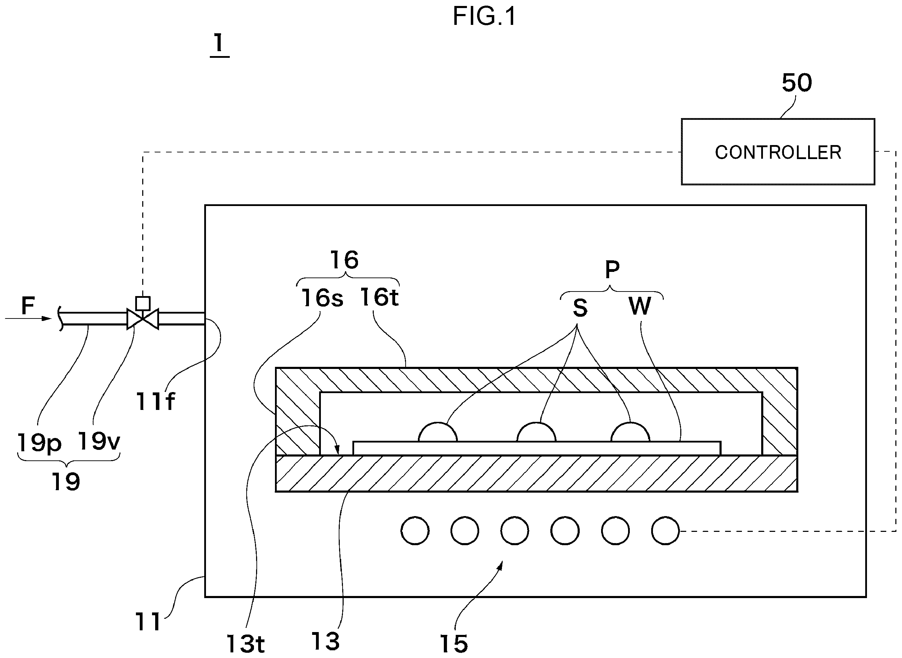

To achieve the above object, a soldered product manufacturing device according to the first aspect of the present invention includes, as shown in FIG. 1, for example, a stage 13 on which a substrate W is placed, solder being arranged on the substrate W; a cover 16 configured to cover at least an entire upper part of the substrate W placed on the stage 13 at a predetermined distance, the predetermined distance being a shortest distance between the solder arranged on the substrate W and the cover 16; a chamber 11 configured to house the stage 13 and the cover 16; a heating portion 15 configured to heat the substrate W placed on the stage 13; and a reducing gas supply device 19 configured to supply a reducing gas F for reducing oxide into the chamber. Here, the solder arranged on the substrate is typically a completed solder bump or a raw material solder that is a raw material for the solder bump.

With such a configuration, in which the cover is provided, it is possible to suppress adhesion to the substrate of the substance which had evaporated from a substance on the substrate and then has condensed, and the ability to suppress heat radiation around the substrate which has been heated makes it possible to increase the speed of reduction in which the reducing gas reacts with the oxide. Further, it is possible to avoid contact of the cover with the solder, and to prevent the solder from being adversely affected.

As for a soldered product manufacturing device according to the second aspect of the present invention, in the soldered product manufacturing device 1 according to the first aspect, the shortest distance is 0.1 mm to 20 mm.

With such a configuration, it is possible to increase the speed of reduction in which the reducing gas acts on the oxide generated on the substrate and the solder, and to improve productivity by shortening the processing time.

As for a soldered product manufacturing device according to the third aspect of the present invention, as shown in FIG. 1, for example, in the soldered product manufacturing device 1 according to the first aspect, predetermined distance is a shortest distance between the substrate and a portion of the cover above the substrate.

With such a configuration, it is possible to suppress an increase in the size of the chamber.

As for a soldered product manufacturing device according to the fourth aspect of the present invention, as shown in FIG. 1, for example, in the soldered product manufacturing device 1 according to any one of the first to third aspects, the heating portion 15 is configured to heat the substrate W by heating the stage 13 with the substrate W placed thereon; and the cover 16 is configured to be in contact with the stage 13 to receive heat transferred from the stage 13.

With such a configuration, in which the cover contacts the stage to be heated, it is possible to suppress condensation of a substance on the cover by raising the temperature of the cover to a temperature that is equal to or more than the condensation temperature of the substance.

As for a soldered product manufacturing device according to the fifth aspect of the present invention, as shown in FIG. 1, for example, in the soldered product manufacturing device 1 according to the fourth aspect, the cover 16 is configured to enclose a space around the substrate W placed on the stage 13.

With such a configuration, it is possible to suppress heat radiation from the space enclosed by the cover, and to increase the speed of reduction in which the reducing gas reacts with the oxide.

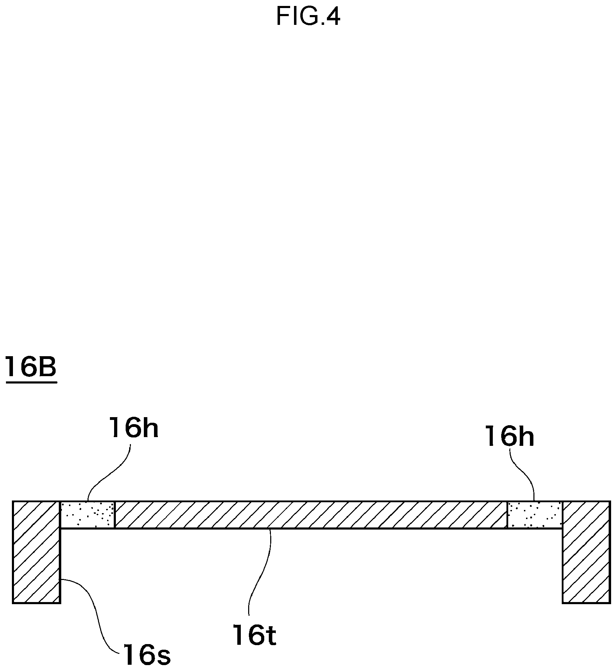

As for a soldered product manufacturing device according to the sixth aspect of the present invention, as shown in FIG. 4, for example, in the soldered product manufacturing device 1 according to any one of the first to fifth aspects, the cover 16B includes a mesh portion 16h configured to allow an evaporated substance generated from a substance on the substrate to pass through but not to allow the substance having been liquefied or solidified to pass through.

With such a configuration, in which the evaporated substance is released to the outside of the cover via the mesh portion but the liquefied or solidified substance does not enter the inside of the cover, it is possible to suppress adhesion of the condensed substance to the substrate.

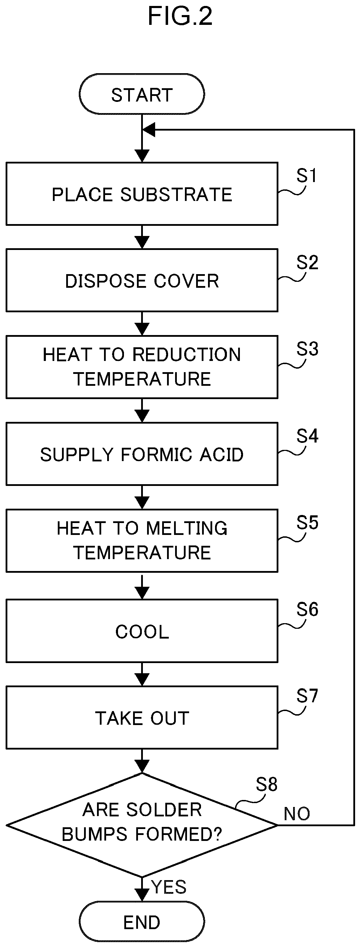

As for a method for manufacturing a soldered product according to the seventh aspect of the present invention, as shown in FIGs. 1 and 2, for example, the method is a method using the soldered product manufacturing device of any one of the first to sixth aspects, and the method includes placing the substrate W on the stage 13 (S1), the solder being arranged on the substrate W; covering at least the entire upper part of the substrate W placed on the stage 13 with the cover 16 at a distance from the solder (S2); heating the substrate W after covering at least the upper part of the substrate W placed on the stage 13 with the cover 16 at a distance from the solder (S3); and supplying the reducing gas F into the chamber 11 (S4).

With such a configuration, it is possible to manufacture a soldered product without causing a substance generated from a substance on the substrate to adhere to the substrate, and to improve productivity by increasing the speed of reduction during the manufacture.

As for a method for manufacturing a soldered product according to the eighth aspect of the present invention, as shown in FIGs. 1 and 2, for example, in the method for manufacturing a soldered product according to the seventh aspect, in covering at least the upper part of the substrate W placed on the stage 13 with the cover 16 at a distance from the solder (S2), a shortest distance from the solder to the cover 16 is 0.1 mm to 20 mm.

With such a configuration, it is possible to suppress heat radiation around the substrate, and to increase the speed of reduction in which the reducing gas reacts with the oxide.

### ADVANTAGE OF THE INVENTION

With the present disclosure, it is possible to suppress adhesion to the substrate of the substance which had evaporated from a substance on the substrate and then has condensed, and to increase the speed of reduction in which the reducing gas reacts with the oxide.

### BRIEF DESCRIPTION OF DRAWINGS

FIG. 1 illustrates a schematic configuration of a soldered product manufacturing device according to an embodiment;
FIG. 2 is a flowchart illustrating the procedure for manufacturing a soldered product;
FIG. 3 illustrates a schematic configuration of a soldered product manufacturing device according to a modification of the embodiment; and
FIG. 4 is a vertical sectional view illustrating a schematic configuration of a modified example of a cover that constitutes the soldered product manufacturing device according to the embodiment.

### DESCRIPTION OF EMBODIMENTS

The present invention will become more fully understood from the detailed description given hereinbelow. Further range of application of the present invention will become clearer from the detailed description given hereinbelow. However, the detailed description and the specific embodiment are illustrated of desired embodiments of the present invention are described only for the purpose of explanation. Various changes and modifications will be apparent to those ordinary skilled in the art on the basis of the detailed description.

The applicant has no intention to give to public any disclosed embodiment. Among the disclosed changes and modifications, those which may not literally fall within the scope of the patent claims constitute, therefore, a part of the present invention in the sense of doctrine of equivalents.

Description will hereinafter be made of an embodiment of the present invention with reference to the drawings. The same or corresponding members are denoted with the same reference numerals in all the drawings, and their descriptions are not repeated.

First, with reference to FIG. 1, a soldered product manufacturing device 1 according to an embodiment will be described. FIG. 1 illustrates a schematic configuration of the soldered product manufacturing device 1. The soldered product manufacturing device 1 is configured to be usable as a solder bump formation device, and to be usable as a soldering device. The solder bump formation device is a device that forms completed solder bumps S (hereinafter referred to simply as "solder bumps S") which are suitable for use in a reflow solder process in which electronic parts are mounted on a substrate W. The solder bumps S are formed by using raw material solder arranged on the substrate W, the solder bumps S being completed with their surfaces rounded in a hemispherical shape. The term "raw material solder" as used herein refers to solder that is not in a hemispherical shape before being completed as the solder bumps S, and typically refers to an appropriate amount of solder paste that has been distributed. The solder that is used as the raw material solder is typically a compound of lead and zinc, tin and/or the like. In the present embodiment, the solder bump formation device is configured to be able to form solder bumps S on the substrate W without using flux. On the other hand, the soldering device is a device that disposes electronic parts on solder bumps S that have been arranged and completed on the substrate W and that solders the electronic parts to the substrate W by melting the solder bumps S through a reflow solder process. The substrate W with the solder bumps S (the substrate W on which the solder bumps S are formed) manufactured by the solder bump formation device and the substrate W on which electronic parts are mounted (a joined substrate in which electronic parts are joined to the solder bumps S on the substrate W) manufactured by the soldering device are each a form of the soldered product. The soldered product manufacturing device 1 can be considered as a general term for the solder bump formation device and the soldering device. In the following, the soldered product manufacturing device 1 is described as being used as the solder bump formation device. The soldered product manufacturing device 1 includes a chamber 11, a stage 13 on which the substrate W is placed, a heater 15 that heats the substrate W, a cover 16 that covers the substrate W, and a formic acid supply portion 19 that supplies a formic acid gas F into the chamber 11.

The chamber 11 forms a space in which a process of forming raw material solder arranged on the substrate W into solder bumps S is performed. The chamber 11 is configured to have a structure that can resist the pressure difference between the inside and the outside. While the chamber 11 is typically formed in a rectangular parallelepiped shape from the viewpoint of ease of manufacture, the outer peripheral wall of the chamber 11 may be formed with a curved surface from the viewpoint of pressure resistance. A formic acid inlet port 11f for introducing the formic acid gas F is formed in the chamber 11. In the present embodiment, the formic acid inlet port 11f is formed at the upper part of the chamber 11. The chamber 11 is provided with a shutter (not illustrated) that opens and closes an opening (not illustrated) for taking the substrate W having solder in and out.

The stage 13 is formed in a plate shape in the present embodiment, and disposed in the chamber 11. The stage 13 includes a placement surface 13t on which the substrate W is placed and which is formed to be flat from the viewpoint of stability of placement. Typically, the back surface of the placement surface 13t is also formed to be flat. The stage 13 is typically installed in the chamber 11 such that the placement surface 13t is horizontal. However, the stage 13 may be inclined with respect to a horizontal plane (the direction in which the placement surface 13t extends has a horizontal component and a vertical component) in the range in which the substrate W can be kept in being placed thereon (in the range in which the substrate W placed thereon does not slip off). The stage 13 is formed from a material that can transfer heat generated by the heater 15 to the substrate W. While the stage 13 is typically formed from graphite, the stage 13 may be formed from metal with high thermal conductivity. The amount of heat transferred from the heater 15 to the substrate W via the stage 13 is such an amount of heat that it can heat the raw material solder arranged on the substrate W to a temperature at which the raw material solder can be melted. The stage 13 is typically configured to be heated to a temperature that is higher than the melting point of the raw material solder arranged on the substrate W. The stage 13 is formed such that the area of the placement surface 13t is larger than that of the substrate W.

The heater 15 is disposed in the chamber 11 at a position below the stage 13 and in proximity to the stage 13 in the present embodiment. In the present embodiment, the heater 15 has a plurality of infrared lamps (hereinafter referred to as "IR lamps") that are arranged along the back surface of the stage 13 at appropriate intervals. The heater 15 heats the substrate W placed on the stage 13 via the stage 13, and corresponds to the heating portion. A cooling portion in a combtooth shape that can contact the back surface of the stage 13 to cool the stage 13 (and hence the substrate W) may be provided between the plurality of IR lamps which are included the heater 15. The cooling portion is preferably configured to be reciprocally movable closer to (when cooling) and away from (when not cooling) the stage 13.

The cover 16 is what covers the substrate W in order to prevent adhesion of unnecessary substances to the substrate W and the like while the substrate W on which raw material solder is arranged is placed on the stage 13. When the cover 16 covers the substrate W appropriately, it is possible to increase the speed of reducing oxide by using the formic acid gas F. In the present embodiment, the cover 16 is sized so as to encompass the substrate W as viewed in plan, in order that the cover 16 can integrally cover the entire substrate W. In other words, the cover 16 can cover a plurality of bumps of raw material solder arranged on the substrate W. In the present embodiment, the cover 16 includes a top plate 16t formed in a rectangular plate shape, and side plates 16s that extend from the four sides of the top plate 16t at a right angle with respect to the top plate 16t. Each of the four side plates 16s extends for the same length in the same direction with respect to the top plate 16t. The side plates 16s are formed to be as short as possible in the range in which the top plate 16t does not contact the substrate W or the raw material solder when the side plates 16s contact the stage 13. The shortest distance between the raw material solder on the substrate W and the top plate 16t (typically the shortest distance between the solder and the cover 16 in the range in which the desired function is achieved) at this time corresponds to the predetermined distance. In this manner, in the present embodiment, the cover 16 is configured to entirely cover the substrate W in cooperation with the stage 13, which can enhance the protection of the substrate W. When the formic acid gas F is supplied into the chamber 11, the formic acid gas F can enter the inside of the cover 16 through the boundary between the cover 16 and the stage 13 because of the characteristics of the formic acid gas F, even if the substrate W is completely covered by the cover 16 and the stage 13. In the case where the substrate W can be protected from unnecessary substances by covering only the upper part of the substrate W, however, the side plates 16s may be removed from the cover 16 to allow the formic acid gas F to easily reach the substrate W. On the other hand, the space around the substrate W is preferably enclosed using the cover 16 which has the side plates 16s, in order to suppress a reduction in the temperature around the substrate W, from the viewpoint of increasing the speed of reducing oxide using the formic acid gas F. The shortest distance between the raw material solder on the substrate W and the top plate 16t is preferably 0.1 mm to 20 mm. From the viewpoint of increasing the speed of reducing oxide using the formic acid gas F, the shortest distance is more preferably 2.0 mm or less, still more preferably 1.5 mm or less. From the viewpoint of suppressing the difficulty in the manufacture of the device, on the other hand, the shortest distance is preferably 0.5 mm or more, still more preferably 1.0 mm or more. In the case where the shortest distance between the raw material solder on the substrate W and the top plate 16t varies among the plurality of bumps of raw material solder arranged on the substrate W, the shortest distance for each of the bumps is preferably in the range of 0.1 mm to 20 mm. The cover 16 is preferably formed from a material with high thermal conductivity, and typically formed from metal.

The formic acid supply portion 19 includes a formic acid source (not illustrated), a pipe 19p that leads the formic acid gas F from the formic acid source to the chamber 11, and a control valve 19v disposed in the pipe 19p. The formic acid source (not illustrated) includes an evaporation portion that evaporates the formic acid, and is configured to be able to supply the evaporated formic acid F into the chamber 11. The pipe 19p is connected to the formic acid inlet port 11f. The formic acid supply portion 19 is configured such that the evaporated formic acid F is supplied into the chamber 11 when the control valve 19v is opened, and such that the supply of the formic acid gas F into the chamber 11 is stopped when the control valve 19v is closed. The formic acid gas F can reduce oxide of the substrate W and the solder by supplying the formic acid gas F to the substrate W and the solder at the reduction temperature, and corresponds to the reducing gas. The formic acid supply portion 19 supplies the formic acid gas F as the reducing gas, and corresponds to the reducing gas supply device. In the soldered product manufacturing device 1, oxide of the substrate W and the solder can be reduced, even without using flux, by supplying the formic acid gas F to the substrate W and the solder at the reduction temperature.

The soldered product manufacturing device 1 further includes a controller 50 that controls operation of the soldered product manufacturing device 1. The controller 50 is connected to the heater 15 through a wire or wirelessly, and configured to be able to heat the stage 13 by turning on and off the heater 15 and changing the output of the heater 15. The controller 50 is also connected to the formic acid supply portion 19 through a wire or wirelessly, and configured to be able to supply the formic acid gas F to the chamber 11 through open and close operation of the control valve 19v.

Next, with reference to FIG. 2, a method for manufacturing a soldered product (here, a method for manufacturing a solder bump formation substrate) using the soldered product manufacturing device 1 will be described. FIG. 2 is a flowchart illustrating the procedure for manufacturing a solder bump formation substrate (soldered product). FIG. 1 will be referenced as appropriate when the configuration of the soldered product manufacturing device 1 is mentioned in the following description of the method for manufacturing a solder bump formation substrate. The following description of the method for manufacturing a solder bump formation substrate using the soldered product manufacturing device 1 also describes the operation of the soldered product manufacturing device 1.

To manufacture a solder bump formation substrate, first, a substrate W on which raw material solder is arranged is taken into the chamber 11 and is placed on the placement surface 13t of the stage 13 (S1: placement step). After the substrate W on which the raw material solder is arranged is placed on the stage 13 in the chamber 11, the cover 16 is disposed on the stage 13 so as to cover the substrate W on which the raw material solder is arranged (S2: covering step). At this time, the cover 16 is disposed on the stage 13 such that the raw material solder and the substrate W do not contact the cover 16. In addition, the shortest distance between each of the raw material solder arranged on the substrate W and the cover 16 is set to a predetermined distance. The predetermined distance here is 0.1 mm to 20 mm. After the cover 16 is disposed, the controller 50 turns on the heater 15 to heat the stage 13 and the substrate W, which has the raw material solder, to a reduction temperature (S3). The reduction temperature is a temperature that is lower than the melting point of the raw material solder arranged on the substrate W and that is suitable to perform a reducing process on an oxide film of the raw material solder and the substrate W using the formic acid F. When the stage 13 is heated by the heater 15, heat is also transferred to the cover 16, which is in contact with the stage 13, to also heat the cover 16. The internal space surrounded by the cover 16 and the stage 13 is also heated to a high temperature.

Next, when the temperature of the stage 13 is raised to the reduction temperature, the controller 50 opens the control valve 19v to supply the formic acid gas F into the chamber 11 (S4: reducing gas supply step). By supplying the formic acid gas F into the chamber 11, a reducing process of reducing an oxide film formed on the raw material solder and the surface of the substrate W and the like using the formic acid F is performed. At this time, the shortest distance between the raw material solder arranged on the substrate W and the cover 16 has been set to the predetermined distance, and thus the speed of reducing the oxide film using the formic acid gas F can be increased. This increase in the reduction speed is considered to be because the space around the substrate W is relatively small to suppress heat radiation and/or the number of collisions of formic acid molecules against the oxide film is increased, since the shortest distance between the raw material solder and the cover 16 is set to the predetermined distance. Removing the oxide film using the formic acid F can avoid using flux, which allows the omission of the subsequent step of washing flux. In the case where the oxide film can be removed even if the formic acid gas F is supplied into the chamber 11 before the temperature of the stage 13 is raised to the reduction temperature, the reducing gas supply step (S4) may be performed before or concurrently with the step of heating to the reduction temperature (S3).

When the reducing process in which the formic acid F is used is completed, the controller 50 increases the output of the heater 15 to heat the stage 13 and the substrate W with the raw material solder to a melting temperature which is a predetermined temperature that is higher than the melting point of the raw material solder (S5). Consequently, the raw material solder on the substrate W is melted into a hemispherical shape. When the raw material solder is formed into a hemispherical shape, the controller 50 stops heating with the heater 15, and discharges the formic acid gas F from the chamber 11 to cool the substrate W which has hemispherical solder (S6). Heating is continued from the step of heating to the reduction temperature (S3) until the melting temperature is reached immediately before heating with the heater 15 is stopped, and this period corresponds to the heating step. When the hemispherical solder located on the substrate W is solidified by being cooled after heating with the heater 15 is stopped, completed solder bumps S are formed. After that, the substrate Won which the solder bumps S are formed (which is a form of the soldered product and may be hereinafter referred to as "product P") is taken out of the chamber 11 (S7). While a substrate W that has solder bumps S is obtained in this manner, it is determined for confirmation whether or not solder bumps S are formed appropriately (S8). In the case where solder bumps S are not formed, the process returns to the placement step (S1), and the above flow is performed again in order to form solder bumps S. In the case where solder bumps S are formed, on the other hand, the manufacture of a solder bump formation substrate (product P) is ended. The solder bump formation substrate (product P) has been manufactured through the sequence of steps, and then the solder bump formation substrate (product P) is sent to the subsequent process. The above flow is repeatedly performed in the case where another solder bump formation substrate (product P) is to be manufactured subsequently.

When the raw material solder and the substrate W are heated to the reduction temperature (S3) and the formic acid gas F is supplied (S4) in the above flow, there occurs a substance produced by a part of components of the raw material solder and/or the substrate W being evaporated and/or a substance produced by combining the substance with the formic acid (hereinafter referred to as "evaporated substances"), even when heating to the melting temperature (S5) in some cases. The evaporated substances are diffused in the chamber 11. When the raw material solder is melted into a hemispherical shape and the temperature in the chamber 11 is lowered by stopping heating with the heater 15, the evaporated substances are liquefied or solidified (hereinafter referred to as "condensed"). The condensed evaporated substances (which have been referred to as "unnecessary substances" in the above description, and which will hereinafter be referred to as "condensed substances") may adhere to and/or be deposited on the inner walls and the like of the chamber 11. In the process of manufacturing a solder bump formation substrate, the condensed substances which have been deposited on the inner walls and the like of the chamber 11 so far are occasionally scattered when the formic acid gas F is supplied into the chamber 11, for example. In the present embodiment, the substrate W on which the raw material solder is arranged is covered by the cover 16 when solder bumps S are formed from the raw material solder. Thus, adhesion of the condensed substances to the substrate W and the like can be prevented even in the case where the condensed substances are scattered in the chamber 11. Even if the temperature in the chamber 11 is lowered and the condensed substances are produced before the product P is taken out of the chamber 11, the space inside the stage 13 and the cover 16 which have been heated is still at a high temperature in spite of having been cooled to a temperature at which the solder is solidified, which can suppress condensation of the evaporated substances.

The solder bump formation substrate (product P) manufactured by the method for manufacturing a solder bump formation substrate discussed above can be used as a target object to which electronic parts are to be soldered. An electronic parts mounted substrate (joined substrate), which is a form of the soldered product, can be manufactured by soldering electronic parts to the solder bump formation substrate (product P). The soldered product manufacturing device 1 can be used as a soldering device as discussed earlier, and thus can manufacture an electronic parts mounted substrate. In the case where the soldered product manufacturing device 1 is used as a soldering device, the soldered product manufacturing device 1 is configured in the same manner as in the case where the soldered product manufacturing device 1 is used as a solder bump formation device as discussed above, and most of the description of the solder bump formation device made above applies. In the case where the soldered product manufacturing device 1 is used as a soldering device, the description of the solder bump formation device made above should be mainly read as follows. In the soldering device, the chamber 11 forms a space in which a process of soldering electronic parts to the substrate W by melting the solder bumps S arranged on the substrate W is performed. The amount of heat transferred from the heater 15 to the substrate W via the stage 13 is such an amount of heat that can heat the solder bumps S arranged on the substrate W to a temperature at which the solder bumps S can be melted. The cover 16 is configured such that the shortest distance between the solder bumps S on which electronic parts are disposed and the cover 16 is the predetermined distance discussed earlier. While the flow indicated in FIG. 2 can be basically applied also to a method for manufacturing an electronic parts mounted substrate (soldered product), the description is preferably read as follows. In the placement step (S1), a substrate W on which solder bumps S are arranged and on which electronic parts are disposed (supplied) is placed on the stage 13 in the chamber 11. The soldered product to be taken out of the chamber 11 in step (S7) is a substrate in which the electronic part is secured to the solder on the substrate W (electronic parts mounted substrate). It is determined in step (S8) whether or not the electronic part is appropriately soldered to the substrate W. The process returns to the placement step (S1) in the case where the electronic part is not soldered, and the manufacture of an electronic parts mounted substrate (soldered product) is ended in the case where the electronic part is soldered. Also in the method for manufacturing an electronic parts mounted substrate (soldered product) using a soldering device, the reduction speed can be increased by performing the process (S3 to S4) of reducing the oxide film with the substrate W covered by the cover 16.

As has been described above, the soldered product manufacturing device 1 according to the present embodiment is provided with the cover 16. Thus, adhesion of the condensed substances to the substrate W and the like can be prevented even in the case where the condensed substances are scattered in the chamber 11. Heat is transferred from the stage 13 to the cover 16 with the cover 16 in contact with the stage 13. Thus, the space surrounded by the stage 13 and the cover 16 can be kept at a high temperature, which makes it possible to suppress condensation of evaporated substances around the cover 16 and suppress deposition of the condensed substances on the cover 16. With the shortest distance between the solder on the substrate W and the cover 16, which covers the substrate W, set to the predetermined distance, the speed of reducing the oxide film using the formic acid gas F in the reducing process can be increased. With the method for manufacturing a solder bump formation substrate according to the present embodiment, the product P can be manufactured without causing the condensed substances to adhere to the substrate W and the like, which allows the omission of subsequent washing. With the method for manufacturing a soldered product according to the present embodiment, the speed of reducing the oxide film using the formic acid gas F in the reducing process can be increased.

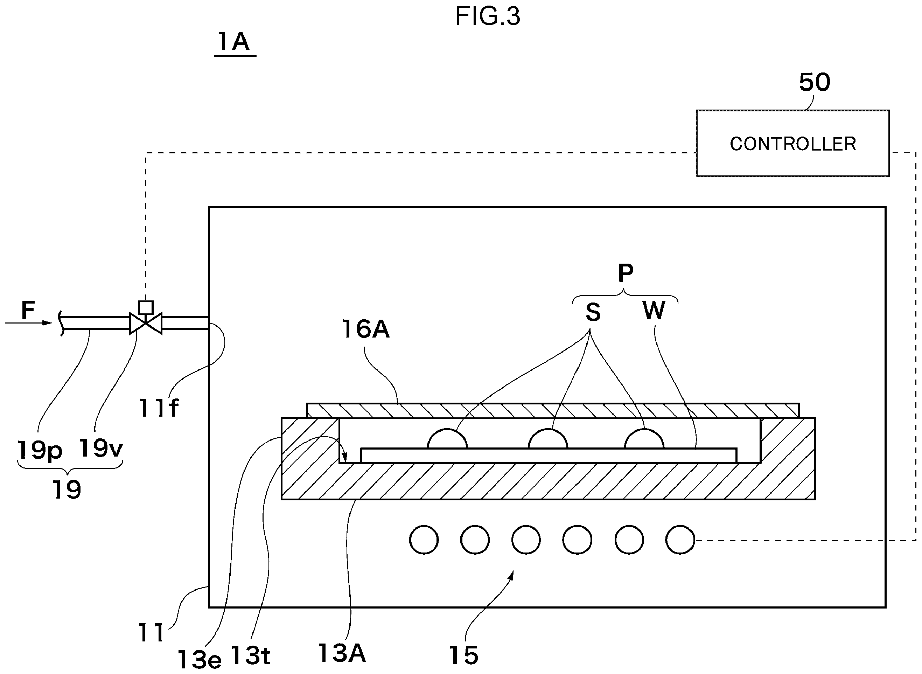

Next, with reference to FIG. 3, a soldered product manufacturing device 1A according to a modification of the embodiment will be described. FIG. 3 illustrates a schematic configuration of the soldered product manufacturing device 1A. The soldered product manufacturing device 1A is different from the soldered product manufacturing device 1 (see FIG. 1) mainly in including a stage 13A that includes a placement surface 13t formed one step lower and a cover 16A formed as a plate member, in place of the stage 13 (see FIG. 1) and the cover 16 (see FIG. 1) respectively. The stage 13A is configured such that the outer periphery of the placement surface 13t is surrounded by an edge 13e that is one step higher than the placement surface 13t. The height of the edge 13e around the placement surface 13t is preferably as low as possible in the range in which the highest portion of the substrate W on which solder (raw material solder or solder bumps S) is arranged does not reach the top end of the edge 13e when the substrate W with the solder is placed on the placement surface 13t. The cover 16A is configured to include only the top plate 16t (see FIG. 1) of the cover 16 (see FIG. 1), and include no side plates 16s (see FIG. 1). The configuration of the soldered product manufacturing device 1A is otherwise the same as that of the soldered product manufacturing device 1 (see FIG. 1). The thus configured soldered product manufacturing device 1A includes the cover 16A with a simple configuration, which facilitates opening and closure of the cover 16A.

In the above description, although the heater 15 is disposed in the chamber 11, the heater 15 may be disposed outside the chamber 11 (e.g. under the bottom surface of the chamber 11) and a portion of the chamber 11 located between the heater 15 and the stage 13 may be rendered transparent to heat the stage 13 using radiant heat from the heater 15.

In the above description, although the process of reducing the oxide film of the substrate W and the solder is performed using formic acid, the process of reducing the oxide film of the substrate W and the solder may be performed using a gas of carboxylic acid other than the formic acid as the reducing gas.

In the above description, the formic acid gas F supplied into the chamber 11 and the evaporated substances produced by heating the substrate W and the like are moved between the inside and the outside of the cover 16 via the boundary between the cover 16 and the stage 13 in the case where the cover 16 is configured to include a top plate 16t and side plates 16s. However, as in a cover 16B according to a modification illustrated in FIG. 4, mesh portions 16h may be provided and the evaporated substances may be moved from the inside to the outside of the cover 16B via the mesh portions 16h. The mesh portions 16h are configured to allow evaporated substances to pass through and condensed substances not to pass through. The phrase "allow condensed substances not to pass through" refers to passing through condensed substances only to such a degree that does not adversely affect the quality of the product P, rather than not passing through condensed substances at all. That is, the phrase refers to substantially not passing through condensed substances. While the mesh portions 16h are typically provided in the top plate 16t, the mesh portions 16h may be provided in the side plates 16s, in place of or in addition to the top plate 16t. The mesh portions 16h can also pass through the formic acid gas F. Thus, in the case where the cover 16B is used, it is possible to effectively prevent the condensed substances from contacting the substrate W and the like and to facilitate supply of the formic acid gas F to the vicinity of the substrate W. The configuration of the mesh portions 16h of the cover 16B is also applicable to the cover 16A illustrated in FIG. 3.

In the description that has been made so far, the soldered product manufacturing device and the method for manufacturing a soldered product according to the embodiments of the present invention have been described mainly with reference to FIG. 1 to FIG. 4 as the example. However, the configurations, structures, numbers, arrangements, shapes, materials, and the like of each of the sections are not limited to the above specific example, but solely by the appended claims.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications falling under the scope of the appended claims.

## Claims

1. A soldered product manufacturing device (1) comprising:
a stage (13) on which a substrate (W) is placed, solder being arranged on the substrate;
a cover (16) configured to cover at least an entire upper part of the substrate placed on the stage at a predetermined distance, the predetermined distance being a shortest distance between the solder arranged on the substrate (W) and the cover (16);
a chamber (11) configured to house the stage and the cover;
a heating portion (15) configured to heat the substrate placed on the stage; and
a reducing gas supply device (19) configured to supply a reducing gas (F) for reducing oxide into the chamber.

2. The soldered product manufacturing device of claim 1, wherein the shortest distance is 0.1 mm to 20 mm.

3. The soldered product manufacturing device of claim 1, wherein the predetermined distance is a shortest distance between the substrate (W) and a portion of the cover (16) above the substrate.

4. The soldered product manufacturing device of any one of claims 1 to 3, wherein:
the heating portion (15) is configured to heat the substrate (W) by heating the stage (13) with the substrate placed thereon; and
the cover (16) is configured to be in contact with the stage to receive heat transferred from the stage.

5. The soldered product manufacturing device of claim 4, wherein the cover (16) is configured to enclose a space around the substrate (W) placed on the stage (13).

6. The soldered product manufacturing device of any one of claims 1 to 5, wherein the cover (16B) includes a mesh portion (16h) configured to allow an evaporated substance generated from a substance on the substrate (W) to pass through but not to allow the substance having been liquefied or solidified to pass through.

7. A method for manufacturing a soldered product using the soldered product manufacturing device of any one of claims 1 to 6, the method comprising:
placing (S1) the substrate (W) on the stage (13), the solder being arranged on the substrate;
covering (S2) at least the entire upper part of the substrate placed on the stage with the cover (16) at a distance from the solder;
heating (S3) the substrate to a reduction temperature after covering at least the entire upper part of the substrate placed on the stage with the cover at a distance from the solder; and
supplying (S4) the reducing gas into the chamber (11).

8. The method for manufacturing a soldered product of claim 7, wherein, in covering at least the entire upper part of the substrate (W) placed on the stage (13) with the cover (16) at a distance from the solder, a shortest distance from the solder to the cover is 0.1 mm to 20 mm.

## Patentansprüche

1. Vorrichtung (1) zur Herstellung eines gelöteten Produkts, mit:
einem Tisch (13), auf dem ein Substrat (W) platzierbar ist, wobei Lot auf dem Substrat angeordnet ist;
einer Abdeckung (16), die dazu aufgebaut ist, mindestens einen gesamten oberen Teil des auf dem Tisch platzierten Substrats in einem vorab festgelegten Abstand abzudecken, wobei der vorab festgelegte Abstand ein kürzester Abstand zwischen dem auf dem Substrat (W) angeordneten Lot und der Abdeckung (16) ist;
einer Kammer (11), die dazu aufgebaut ist, den Tisch und die Abdeckung aufzunehmen;
einem Heizabschnitt (15), der dazu aufgebaut ist, das auf dem Tisch platzierte Substrat zu erwärmen; und
einer Reduktionsgas-Zufuhrvorrichtung (19), die dazu aufgebaut ist, ein Reduktionsgas (F) zum Reduzieren von Oxiden in die Kammer zuzuführen.

2. Vorrichtung zur Herstellung eines gelöteten Produkts nach Anspruch 1, wobei der kürzeste Abstand 0,1 mm bis 20 mm beträgt.

3. Vorrichtung zur Herstellung eines gelöteten Produkts nach Anspruch 1, wobei der vorab festgelegte Abstand der kürzeste Abstand zwischen dem Substrat (W) und einem Teil der Abdeckung (16) oberhalb des Substrats ist.

4. Vorrichtung zur Herstellung eines gelöteten Produkts nach einem der Ansprüche 1 bis 3, wobei:
der Heizabschnitt (15) dazu aufgebaut ist, das Substrat (W) zu erwärmen, indem er den Tisch (13) mit dem darauf platzierten Substrat erwärmt; und
die Abdeckung (16) dazu aufgebaut ist, mit dem Tisch in Kontakt zu sein, um vom Tisch übertragene Wärme aufzunehmen.

5. Vorrichtung zur Herstellung eines gelöteten Produkts nach Anspruch 4, wobei die Abdeckung (16) dazu aufgebaut ist, einen Raum um das auf dem Tisch (13) platzierte Substrat (W) einzuschließen.

6. Vorrichtung zur Herstellung eines gelöteten Produkts nach einem der Ansprüche 1 bis 5, wobei die Abdeckung (16B) einen Maschenabschnitt (16h) aufweist, der dazu aufgebaut ist, eine verdampfte Substanz, die aus einer Substanz auf dem Substrat (W) erzeugt wurde, durchzulassen, aber die Substanz, die verflüssigt oder verfestigt wurde, nicht durchzulassen.

7. Verfahren zur Herstellung eines gelöteten Produkts unter Nutzung der Vorrichtung zur Herstellung eines gelöteten Produkts nach einem der Ansprüche 1 bis 6, wobei das Verfahren folgende Schritte umfasst:
Platzieren (S1) des Substrats (W) auf dem Tisch (13), wobei das Lot auf dem Substrat angeordnet ist;
Abdecken (S2) mindestens des gesamten oberen Teils des auf dem Tisch platzierten Substrats mit der Abdeckung (16) in einem Abstand zum Lot;
Erwärmen (S3) des Substrats auf eine Reduktionstemperatur, nachdem zumindest der gesamte obere Teil des auf dem Tisch angeordneten Substrats mit der Abdeckung in einem Abstand von dem Lot bedeckt wurde; und
Zuführen (S4) des Reduktionsgases in die Kammer (11).

8. Verfahren zur Herstellung eines gelöteten Produkts nach Anspruch 7, wobei beim Bedecken zumindest des gesamten oberen Teils des auf dem Tisch (13) angeordneten Substrats (W) mit der Abdeckung (16) in einem Abstand zum Lot ein kürzester Abstand vom Lot zur Abdeckung 0,1 mm bis 20 mm beträgt.

## Revendications

1. Dispositif de fabrication de produits soudés (1) comprenant:
une platine (13) sur laquelle un substrat (W) est placé, de la soudure étant disposée sur le substrat;
un couvercle (16) configuré pour recouvrir au moins une partie supérieure entière du substrat placé sur la platine à une distance prédéterminée, la distance prédéterminée étant une distance la plus courte entre la soudure disposée sur le substrat (W) et le couvercle (16);
une chambre (11) configurée pour loger la platine et le couvercle;
une partie chauffante (15) configurée pour chauffer le substrat placé sur la platine; et
un dispositif de fourniture de gaz réducteur (19) configuré pour fournir un gaz réducteur (F) pour réduire l'oxyde dans la chambre.

2. Dispositif de fabrication de produits soudés selon la revendication 1, dans lequel la distance la plus courte est 0,1 mm à 20 mm.

3. Dispositif de fabrication de produits soudés selon la revendication 1, dans lequel la distance prédéterminée est une distance la plus courte entre le substrat (W) et une partie du couvercle (16) au-dessus du substrat.

4. Dispositif de fabrication de produits soudés selon l'une quelconque des revendications 1 à 3, dans lequel:
la partie chauffante (15) est configurée pour chauffer le substrat (W) en chauffant la platine (13) avec le substrat placé sur elle; et
le couvercle (16) est configuré pour être en contact avec la platine pour recevoir la chaleur transférée depuis la platine.

5. Dispositif de fabrication de produits soudés selon la revendication 4, dans lequel le couvercle (16) est configuré pour délimiter un espace autour du substrat (W) placé sur la platine (13).

6. Dispositif de fabrication de produits soudés selon l'une quelconque des revendications 1 à 5, dans lequel le couvercle (16B) inclut une partie maillée (16h) configurée pour permettre à une substance évaporée générée à partir d'une substance sur le substrat (W) de passer à travers mais pour ne pas permettre à la substance ayant été liquéfiée ou solidifiée de passer à travers.

7. Procédé pour fabriquer un produit soudé utilisant le dispositif de fabrication de produits soudés selon l'une quelconque des revendications 1 à 6, le procédé comprenant:
la mise en place (S1) du substrat (W) sur la platine (13), la soudure étant disposée sur le substrat;
le recouvrement (S2) d'au moins toute la partie supérieure du substrat placé sur la platine avec le couvercle (16) à une distance de la soudure;
le chauffage (S3) du substrat à une température de réduction après le recouvrement d'au moins toute la partie supérieure du substrat placé sur la platine avec le couvercle à une distance de la soudure; et
la fourniture (S4) du gaz réducteur dans la chambre (11).

8. Procédé pour fabriquer un produit soudé selon la revendication 7, dans lequel, lors du recouvrement d'au moins toute la partie supérieure du substrat (W) placé sur la platine (13) avec le couvercle (16) à une distance de la soudure, une distance la plus courte de la soudure au couvercle est 0,1 mm à 20 mm.
